# EUROPEAN PATENT SPECIFICATION

(11) **EP 1 719 098 B1**
(45) Date of publication and mention of the grant of the patent: **24.12.2008**
(21) Application number: 05714051.9
(22) Date of filing: 24.02.2005
(51) Int. Cl.: G09F 9/30, G02B 6/04

(54) **TILED DISPLAY**
MOSAIK-ANZEIGE
AFFICHAGE A TUILES

(30) Priority: 24.02.2004 US 785624
(43) Date of publication of application: 08.11.2006
(73) Proprietor: Eastman Kodak Company, Rochester NY 14650-2201 (US)
(72) Inventor: COK, Ronald, Steven, Rochester, NY 14625 (US)
(74) Representative: Haile, Helen Cynthia
(86) International application number: PCT/US2005/005999
(87) International publication number: WO 2005/083659

(56) References cited:
- EP-A- 0 179 913
- EP-A- 0 485 235
- EP-A- 1 389 740
- PATENT ABSTRACTS OF JAPAN vol. 2003, no. 12, 5 December 2003 (2003-12-05) & JP 2003 332633 A (SONY CORP), 21 November 2003 (2003-11-21)

## Description

### FIELD OF THE INVENTION

This invention relates generally to a method for manufacturing a tiled display, in particular to a method for manufacturing a tiled display using an optical faceplate.

### BACKGROUND OF THE INVENTION

It is known to increase the size of an electro-optic imaging device such as a flat panel display or an image sensor by forming the device using a plurality of tiles, each tile having a two-dimensional array of pixels, see for example US Patent 6,262,696 issued July 17, 2001 to Seraphim et al. Large tiled displays can also be made using an array of fiber optic panels in association with smaller displays. The fiber optic panels reduce the edge gap between the display tiles as described in US Patent 4,299,447 issued November 10, 1981 to Soltan et al. WO 99/41732, Matthies et al., published August 19, 1999, describes forming a tiled display device from display tiles having pixel positions defined up to the edge of the tiles. One example of the use of tiles to increase the size of an image sensor is shown in US Patent 5,572,034, issued November 5, 1996 to Karellas.

EP 0 179 913 discloses a large liquid crystal display in which many liquid crystal display elements are arranged on a plane; the display portion of each liquid crystal display element is covered with light guide elements, which constitute the screen.

However, construction of tiled imaging devices is difficult. No two tiles, whether used alone or with fiber optic faceplates, are precisely alike and the human eye is extremely sensitive to differences in color, brightness, and contrast in localized areas. There are calibration techniques by which the uniformity and color balance of a display or image sensor tile can be adjusted, but these are difficult, require re-adjustment over time, and are often inadequate. Moreover, the seams between the tile edges are very noticeable as the human eye is very sensitive to straight horizontal and vertical lines.

The assembly of flat-panel tiles is also a problem. In order to ameliorate the problems associated with tile seams, the tiled displays must be assembled very carefully and with great precision. This process is expensive and slow and products are prone to fall out of alignment over time without expensive forms or brackets to align the tiles once they are placed.

Moreover, the use of multiple display devices raises the cost of the larger display significantly. It can be true that single-substrate display devices are less expensive than tiled displays of a comparable size.

There is a need therefore for a method for manufacturing a tiled electro-optic display device that reduces the costs of a tiled display device while reducing the visibility of tile non-uniformities and tile seams, and that enhances the mechanical assembly of the tiles.

### SUMMARY OF THE INVENTION

In accordance with one embodiment, the present invention is directed towards a method of manufacturing a tiled display comprising the steps of: a) selecting a plurality of flat-panel displays, each flat-panel display having a display area comprising a plurality of pixels arranged in an array and having at least one defective pixel; and b) forming a tiled display by locating one or more faceplates in alignment with the plurality of flat-panel displays, the one or more faceplates having a plurality of lightpipes in an array, the lightpipes having input and output end faces for transmitting light from the display areas of the flat-panel displays to a display surface of the tiled display, wherein the input end face of each of the lightpipes has an area larger than the area of one pixel of the selected flat-panel displays, and wherein each lightpipe transmits light from more than one pixel from the display area of the flat-panel displays to the display surface of the tiled display.

In accordance with a second embodiment, the present invention is directed towards a tiled display comprising: a) a plurality of flat-panel displays, each flat-panel display having a display area comprising a plurality of pixels arranged in an array and having at least one defective pixel; and b) one or more faceplates located in alignment with the plurality of flat-panel displays, the one or more faceplates having a plurality of lightpipes in an array, the lightpipes having input and output end faces for transmitting light from the display areas of the flat-panel displays having a first size to display surface of the tiled display having a larger size parallel to the display areas of the flat-panel displays, wherein the input end face of each of the lightpipes has an area larger than the area of one pixel of the selected flat-panel displays, and wherein each lightpipe transmits light from more than one pixel from the display area of the flat-panel displays to the display surface of the tiled display.

### ADVANTAGES

The present invention has the advantage of providing a tiled flat-panel array at reduced costs and improved performance.

### BRIEF DESCRIPTION OF THE DRAWINGS

Fig. 1 is a flow diagram illustrating one embodiment of the method of the present invention;
Fig. 2 is a schematic diagram of a prior art tiled display having a two-by-two array of tiles;
Fig. 3 a is a schematic diagram of an inter-digitated pixel layout for a tile according to one embodiment of the present invention;
Fig. 3b is a schematic diagram of an inter-digitated pixel layout for a tile according to another embodiment of the present invention;
Fig. 4 is a schematic diagram of a two-by-two array of inter-digitated tiles according to an embodiment of the present invention using the pixel layout of Fig. 3a;
Fig. 5 is a schematic diagram of a two-by-two array of inter-digitated tiles having an alternative inter-digitation according to an embodiment of the present invention;
Fig. 6 is a side view of two aligned tile modules with faceplates and substrates according to an embodiment of the present invention;
Fig. 7a is a side view of a two-by-two array of lightpipes aligned with pixels on a substrate according to an embodiment of the present invention; and
Fig. 7b is a top view of the two-by-two array of lightpipes aligned with pixels on a substrate as shown in Fig. 7a according to an embodiment of the present invention;

It will be understood that the figures are not to scale since the pixel elements are much smaller than the display device.

### DETAILED DESCRIPTION OF THE INVENTION

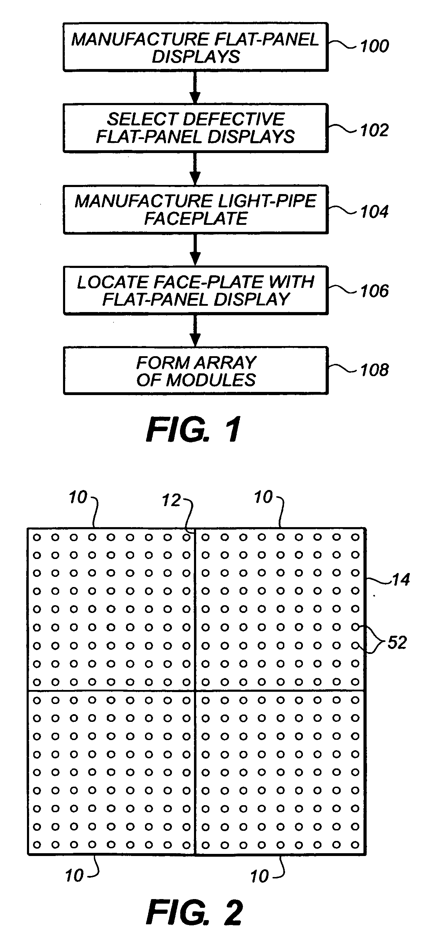

Referring to Fig. 1, a method of manufacturing a tiled display system in accordance with one embodiment of the invention comprises manufacturing **100** a plurality of flat-panel displays, each flat-panel display having a display area comprising a plurality of pixels arranged in an array; selecting **102** flat-panel displays having at least one defective pixel; manufacturing **104** a faceplate having a plurality of lightpipes in an array, the lightpipes having input and output end faces for transmitting light from the display areas of the flat-panel displays to a display surface of the tiled display, wherein the input end face of each of the lightpipes has an area larger than the area of one pixel; and locating **106** one or more faceplates in alignment with the plurality of flat-panel displays to **108** form a tiled display, wherein each lightpipe of the one or more faceplates transmits light from more than one pixel from the display area of the flat-panel displays to the display surface of the tiled display. In preferred embodiments, the display areas of the flat-panel displays have a first size, and the lightpipes transmit light from the display areas to a display surface of the tiled display having a second size larger than that of the display areas of the flat-panel displays. Further, the display surface of the tiled display is preferably parallel to the display areas of the flat-panel displays. The tiled display may be formed by locating individual faceplates in alignment with each selected flat-panel display, and aligning adjacent edges of the individual faceplates in an array. Alternatively, the tiled display may be formed by locating multiple selected flat-panel displays in alignment with a single faceplate. In such alternative embodiment, single faceplates aligned with multiple selected flat-panel displays may themselves also be aligned in an array.

The method of the present invention reduces costs by selecting flat-panel displays that are normally unacceptable for use as individual displays in conventional application, for example monitors or video devices. To construct a tiled display device according to the present invention, flat-panel displays having a plurality of pixels are first manufactured. It is well known that such manufacturing processes are imperfect and yield a number of flat-panel displays with defective pixels. These pixels may be defective in color, dynamic range, or may be stuck on or off. Depending on the intended application, a certain number of bad pixels may be acceptable. Those displays whose quality is unacceptable are wasted. According to the present invention, displays having at least one defective pixel are selected. Because the display system of the present invention utilizes displays that are normally rejected, the costs of the larger display are greatly reduced.

Faceplates having a plurality of lightpipes are formed in an array complementary to the pixel array of the flat-panel displays, but at a lower resolution (i.e., each lightpipe transmits light from more than one pixel). In one embodiment, each faceplate is aligned with one of the selected flat-panel displays and held in place, for example through adhesives or fasteners in a frame. Alternatively, multiple selected flat-panel displays may be located in alignment with a single faceplate. Electronic components (e.g. printed circuit boards with circuitry) or connectors may also be fastened to the display. The faceplates may then be located edge-to-edge to form a larger array. The faceplates may have inter-digitated edges to aid alignment.

The pixels of one or more of the lightpipes of the flat-panel displays are defective. As each lightpipe transmits light from more than one pixel, the light from any defective pixel will be averaged with neighboring good pixels to reduce effect of the defective pixel. If each lightpipe covers a sufficiently large number of pixels, it is possible that no software correction will be necessary to accommodate the one or more defective pixels. The defective elements may not be perceptible when combined with a larger number of good pixels. For example, if a lightpipe has a 10-by-10 array of pixels (100 in total), the presence of a bad pixel within the 100 pixels may not be noticeable. In this case, no correction need be made.

However, if the defective pixels are noticeable, compensation may be provided in a variety of ways. If a pixel is stuck off, the other pixels using the same lightpipe may be made brighter. This effectively reduces the lifetime of the display. Alternatively, a reduced brightness may be acceptable if the uniformity of the display is maintained by likewise reducing the brightness of the other pixels to a common brightness. If a pixel is stuck on, a similar correction may be made by turning on a pixel in every lightpipe (reducing the overall contrast of the display), or the other pixels using the same lightpipe may be made dimmer. If color elements are inoperative, color corrections can also be made either within the pixels associated with a single lightpipe or by correcting the light output of the other lightpipes.

The corrections may be calculated by measuring the light output of the display with, for example, a digital camera. The uniformity, dynamic range, black level, white level, and color may be measured by displaying a variety of test images on the display. If any corrections for pixels are necessary to maintain the quality of the display, they may be calculated and implemented in the electronics, typically through lookup tables, amplifiers, and the like.

Referring to Fig. 2, a tiled display in accordance with one possible embodiment of the invention includes a two-by-two array of tiles **10**, having edges **14** and an array of pixel groups. Light from each pixel group is transmitted through a single lightpipe **52.** The edges **14** of the tiles **10** are aligned to produce a seam **12** between the edges of the tiles **14** and the last row or column of lightpipes **52** in the arrays. (The illustration of Fig. 2 is not drawn to scale to clarify the description). While the arrangement of Fig. 2 advantageously has a simple structure, the edge seam **12** may be visible to the human eye because it is straight, is horizontal or vertical, and has a direction that is the same as the pixel rows and columns. Moreover, small differences between the tiles, for example color, brightness, sensitivity or noise may be visible to the human eye.

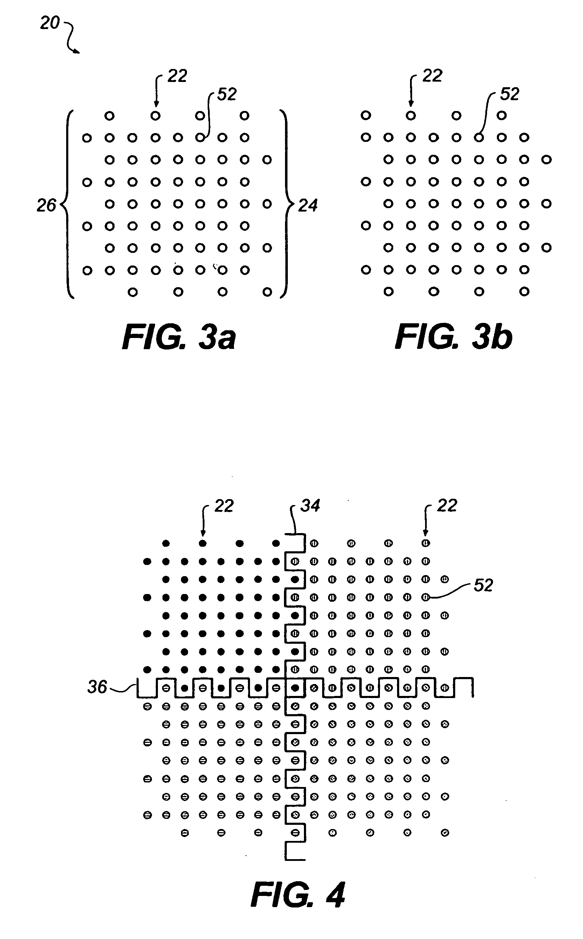

Referring to Figs. 3a and 3b, two tiles having edge structures according to two preferred embodiments of the method of the present invention is shown. In Figs. 3a and 3b, the four edges of tile **10** are non-linear and the rows and columns of lightpipes have a stepped pattern such that each row or column **22** extends beyond the adjacent row or column on alternating ends to form an inter-digitated array **20** of lightpipes. Moreover, the rows and columns on the opposing edges **24** and **26** of each tile have a complementary form such that the rows and columns on each tile edge can be inter-digitated as shown in Fig. 4. Referring to Fig. 4, four of the tiles **10** are arranged to form a regular array of lightpipes **52** with the result that lightpipes at the edges of the tiles are inter-digitated to form an inter-digitated column **34** or row **36.** This inter-digitation of the lightpipes at the tile edges has multiple benefits. First, the tile seam is less visible to the human eye because it is not straight, thus reducing the visibility of tile seams. Second, the inter-digitation of lightpipes from two adjacent tiles obscures differences in uniformity between the tiles. Third, the edges of the tiles can no longer slip with respect to each other because the stepped shape of the edge locks the tiles in position with respect to each other. Moreover, the tiles are easier to assemble since they lock into a specific location with respect to each other.

Note that although the illustration of Figs. 3 and 4 show inter-digitation in two dimensions, it is also possible to inter-digitate in only one dimension, for example by rows only or by columns only. This approach provides alignment and visibility improvements in only one dimension but is significantly easier to manufacture.

Applicants have conducted tests with human subjects simulating a tiled display device according to the present invention, on a CRT display that have shown that an inter-digitated edge between tiles increases by as much as fifty percent the threshold at which a global uniformity difference between the tiles is perceptible and reduces the visibility of an edge seam by as much as 50%.

Each tile in a multi-tile device according to the present invention may have a complementary pattern on opposite edges **24** and **26** so that the tiles can be placed together with inter-digitated lightpipes along the edges. Tiles on the edges of a multi-tile device will not have a straight edge. The edges of the tiled array can be masked with a frame to obscure the non-linear external edges. Alternatively, special edge and corner tiles may be created with one or more conventional straight edges.

The pixel control mechanisms for the tiles need not be modified and the row and column controls normally present in a device may operate normally. In a display device, each tile's information overlaps with the neighboring tiles so that neighboring tiles will have edge rows and edge columns of information in common. Referring to Figs. 3 and 4, adjacent tiles overlap by one column or row **22** of pixel groups. This reduces the total number of rows and columns in the entire display by the total overlap amount.

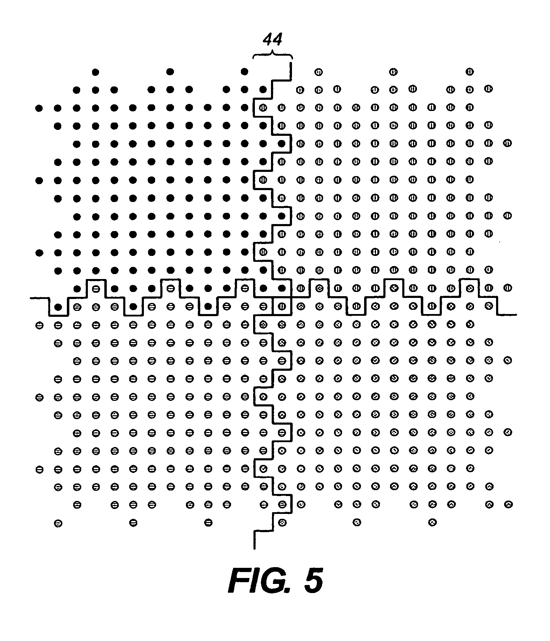

A variety of tile edge shapes may be used. Deeper stair steps that are multiple pixels deep may be used, as shown in Fig. 5. Referring to Fig. 5, the tiles incorporate a stair-step edge that overlaps by two columns or rows **44** of pixel groups. The process may be extended to larger overlaps with improved seam hiding and apparent tile uniformity but at the cost of more overlapped rows or columns.

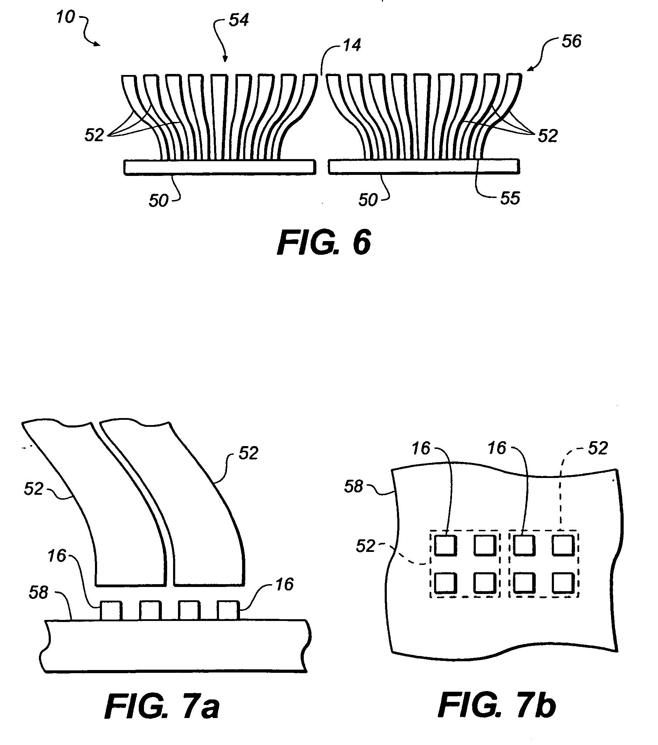

Referring to Fig. 6, the tiles **10** include a flat-panel display 50 with a faceplate **54** comprising an array of lightpipes **52.** Suitable flat-panel displays may be, for example, liquid crystal displays, organic light emitting diode displays, or plasma displays. The faceplates **54** have edges **14** that serve to align one faceplate **54** with another. Each faceplate **54** has two faces, an input face **55** and an output face **56.** The lightpipes **52** have an input side **55** located in close proximity to the flat-panel display **50** that conducts light from the pixels with which the lightpipes are aligned through the body of the lightpipes to the output side **56** from which light is emitted to a viewer. In accordance with preferred embodiments, the output side 56 of the faceplate **54** is larger than the input side **55,** to accommodate non-light emitting areas on the peripheries of individual flat-panel displays **50.** In such embodiment, each individual lightpipe must either be separated by a greater distance on the output side **56** than the input side **55** or must be larger on the output side **56** than on the input side **55.** This allows the faceplates **54** to be aligned along the output sides **56** while providing space for a flat-panel display **50** to be located in alignment on the input side **55.**

Referring to Figures 7a and 7b, a partial cross-section (Fig. 7a) and top view (Fig. 7b) of two lightpipes **52** and their associated light-emitting pixels **16** are shown. The pixels **16** are formed on a substrate **58** and may include multiple sub-elements each emitting a different color to form a single, color pixel. Each lightpipe transmits the light from more than one pixel. In the example shown in Figs. 7a and 7b, each lightpipe is associated with four pixels arranged in a two-by-two array. In practice, the number of pixels associated with each lightpipe will vary depending on the desired resolution of the overall display, the resolution of the individual displays used in each tile, and the number of lightpipes in the overall display.

Because each lightpipe transmits light from more than one pixel, the effective resolution of each tile is reduced. In practice, electronic devices capable of transforming a conventional video or other signal (for example, an HDTV or DVI signal) convert the input signal into a set of signals, each associated with one display tile. The converted signal is at a reduced resolution and transmits a single pixel element signal to all of the pixels associated with each lightpipe.

Such electronic processing equipment is described, for example, in US2004/0008155A.

### PARTS LIST

- 8: electro-optic imaging device
- 10: tile
- 12: seam
- 14: edge
- 16: pixels
- 20: inter-digitated array of lightpipes
- 22: row or column of lightpipes
- 24: tile edge
- 26: tile edge
- 34: inter-digitated column
- 36: inter-digitated row
- 44: interdigitated multiple columns or rows
- 50: flat-panel display
- 52: lightpipe
- 54: faceplate
- 55: input face
- 56: output face
- 58: substrate
- 100: manufacture flat-panel display step
- 102: select step
- 104: manufacture light-pipe faceplate step
- 106: locate step
- 108: form step

## Claims

1. A method of manufacturing a tiled display comprising the steps of:
a) selecting a plurality of flat-panel displays (50), each flat-panel display having a display area comprising a plurality of pixels (16) arranged in an array and having at least one defective pixel;
b) forming a tiled display by locating one or more faceplates in alignment with the plurality of flat-panel displays, the one or more faceplates having a plurality of lightpipes (52) in an array, the lightpipes having input and output end faces for transmitting light from the display areas of the flat-panel displays to a display surface (56) of the tiled display, wherein the input end face of each of the lightpipes has an area larger than the area of one pixel of the selected flat-panel displays, and wherein each lightpipe transmits light from more than one pixel from the display area of the flat-panel displays to the display surface of the tiled display.

2. A tiled display comprising:
a) a plurality of flat-panel displays (50), each flat-panel display having a display area comprising a plurality of pixels (16) arranged in an array and having at least one defective pixel; and
b) one or more faceplates located in alignment with the plurality of flat-panel displays, the one or more faceplates having a plurality of lightpipes (52) in an array, the lightpipes having input and output end faces for transmitting light from the display areas of the flat-panel displays to a display surface (56) of the tiled display, wherein the input end face of each of the lightpipes has an area larger than the area of one pixel of the selected flat-panel displays, and wherein each lightpipe transmits light from more than one pixel from the display area of the flat-panel displays to the display surface of the tiled display.

3. The tiled display claimed in claim 2, wherein the display areas of the flat-panel displays have a first size, and wherein the lightpipes transmit light from the display areas to a display surface of the tiled display having a second size larger than that of the display areas of the flat-panel displays.

4. The tiled display claimed in claim 2, having individual faceplates in alignment with each selected flat-panel display, wherein adjacent edges of the individual faceplates are aligned in an array, and wherein aligned adjacent edges of the faceplates are inter-digitated in at least one dimension.

5. The tiled display claimed in claim 2, having multiple selected flat-panel displays in alignment with a single face plate.

6. The tiled display claimed in claim 5, wherein lightpipes transmitting light from pixel elements along adjacent edges of the flat panel displays are inter-digitated at the display surface of the tiled display in at least one dimension.

7. The tiled display claimed in claim 2 further including a controller for correcting the light output of each lightpipe to a common brightness, color, and dynamic range.

8. The tiled display claimed in claim 2 wherein the flat-panel displays are liquid crystal displays.

9. The tiled display claimed in claim 2 wherein the flat-panel displays are organic light emitting diode displays.

10. The tiled display claimed in claim 2 wherein the flat-panel displays are plasma displays.

## Patentansprüche

1. Verfahren zur Herstellung eines mosaikartigen Bildschirms mit folgenden Schritten:
a) Auswählen einer Vielzahl von Flachbildschirmen (50), von denen jeder einen Bildschirmbereich mit einer Vielzahl von Pixeln (16) aufweist, die in einer Anordnung mit mindestens einem defekten Pixel angeordnet sind;
b) Ausbilden eines mosaikartigen Bildschirms durch Anordnen einer oder mehrerer Frontplatten, die mit der Vielzahl von Flachbildschirmen ausgerichtet sind, wobei die mindestens eine Frontplatte eine Vielzahl von Lichtleitern (52) in einer Anordnung aufweist, wobei die Lichtleiter Eingangs- und Ausgangsstirnseiten aufweisen zum Übertragen von Licht von den Bildschirmbereichen der Flachbildschirme zu einer Bildschirmoberfläche (56) des mosaikartigen Bildschirms, worin die Eingangsstirnseite eines jeden Lichtleiters einen Bereich hat, der größer ist als der Bereich eines Pixels der ausgewählten Flachbildschirme, und worin jeder Lichtleiter Licht von mehr als einem Pixel vom Bildschirmbereich der Flachbildschirme zur Bildschirmoberfläche des mosaikartigen Bildschirms überträgt.

2. Mosaikartiger Bildschirm mit:
a) einer Vielzahl von Flachbildschirmen (50), von denen jeder einen Bildschirmbereich mit einer Vielzahl von Pixeln (16) aufweist, die in einer Anordnung mit mindestens einem defekten Pixel angeordnet sind; und
b) einer oder mehreren Frontplatten, die mit der Vielzahl von Flachbildschirmen ausgerichtet sind, wobei die mindestens eine Frontplatte eine Vielzahl von Lichtleitern (52) in einer Anordnung aufweist, wobei die Lichtleiter Eingangs- und Ausgangsstirnseiten aufweisen zum Übertragen von Licht von den Bildschirmbereichen der Flachbildschirme zu einer Bildschirmoberfläche (56) des mosaikartigen Bildschirms, wobei die Eingangsstirnseite eines jeden Lichtleiters einen Bereich hat, der größer ist als der Bereich eines Pixels der ausgewählten Flachbildschirme, und wobei jeder Lichtleiter Licht von mehr als einem Pixel vom Bildschirmbereich der Flachbildschirme zur Bildschirmoberfläche des mosaikartigen Bildschirms überträgt.

3. Mosaikartiger Bildschirm nach Anspruch 2, worin die Bildschirmbereiche der Flachbildschirme eine erste Größe aufweisen und die Lichtleiter Licht von den Bildschirmbereichen zu einer Bildschirmoberfläche des mosaikartigen Bildschirms übertragen, die eine zweite Größe aufweist, die größer ist als die Bildschirmbereiche der Flachbildschirme.

4. Mosaikartiger Bildschirm nach Anspruch 2, mit einzelnen Frontplatten, die mit jedem ausgewählten Flachbildschirm ausgerichtet sind, wobei benachbarte Ränder der einzelnen Frontplatten in einer Anordnung angeordnet sind und wobei miteinander ausgerichtete benachbarte Ränder der Frontplatten in mindestens einer Dimension digital ineinander verschachtelt sind.

5. Mosaikartiger Bildschirm nach Anspruch 2, mit mehreren ausgewählten Flachbildschirmen, die mit einer einzelnen Frontplatte ausgerichtet sind.

6. Mosaikartiger Bildschirm nach Anspruch 5, worin Lichtleiter, die Licht von Pixelelementen entlang benachbarter Ränder der Flachbildschirme übertragen, an der Bildschirmoberfläche des mosaikartigen Bildschirms in mindestens einer Dimension digital ineinander verschachtelt sind.

7. Mosaikartiger Bildschirm nach Anspruch 2, mit einer Steuereinrichtung zum Einstellen der Lichtabgabe für jeden Lichtleiter auf einen gemeinsamen Helligkeits-, Farb- und Dynamikbereich.

8. Mosaikartiger Bildschirm nach Anspruch 2, worin es sich bei den Flachbildschirmen um Flüssigkristall-Bildschirme handelt.

9. Mosaikartiger Bildschirm nach Anspruch 2, worin es sich bei den Flachbildschirmen um OLED-Bildschirme handelt.

10. Mosaikartiger Bildschirm nach Anspruch 2, worin es sich bei den Flachbildschirmen um Plasma-Bildschirme handelt.

## Revendications

1. Procédé de fabrication d'un dispositif d'affichage à tuiles comprenant les étapes suivantes :
a) sélectionner une pluralité de dispositifs d'affichage à écran plat (50), chaque dispositif d'affichage à écran plat comportant une surface d'affichage renfermant une pluralité de pixels (16) agencés en matrice dont l'un au moins est défectueux ;
b) créer un affichage à tuiles par alignement d'une ou de plusieurs dalles avec la pluralité des dispositifs d'affichage à écran plat, l'une ou plusieurs des dalles comportant une pluralité de conducteurs de lumière (52) formant un ensemble, les conducteurs de lumière ayant des faces terminales d'entrée et de sortie permettant de transmettre la lumière provenant des surfaces d'affichage des dispositifs d'affichage à écran plat à une surface d'affichage (56) du dispositif d'affichage à tuiles. La face terminale d'entrée de chacun des conducteurs de lumière présente une surface plus importante que celle d'un pixel des dispositifs d'affichage à écran plat sélectionnés et dans laquelle chaque conducteur de lumière transmet la lumière depuis plus d'un pixel de la zone d'affichage des dispositifs d'affichage à écran plat vers la surface d'affichage du dispositif d'affichage à tuiles.

2. Dispositif d'affichage à tuiles comprenant :
une pluralité de dispositifs d'affichage à écran plat (50), chaque dispositif d'affichage à écran plat renfermant une surface d'affichage contenant une pluralité de pixels (16) agencés en matrice dont l'un au moins est défectueux ; et
b) une ou plusieurs dalles alignées avec la pluralité des dispositifs d'affichage à écran plat, l'une ou plusieurs des dalles comportant une pluralité de conducteurs de lumière (52) formant un ensemble, les conducteurs de lumière ayant des faces terminales d'entrée et de sortie permettant de transmettre la lumière provenant des surfaces d'affichage des dispositifs d'affichage à écran plat à une surface d'affichage (56) du dispositif d'affichage à tuiles. La face terminale d'entrée de chacun des conducteurs de lumière présente une surface plus importante que celle d'un pixel des dispositifs d'affichage à écran plat sélectionnés et dans laquelle chaque conducteur de lumière transmet la lumière depuis plus d'un pixel de la zone d'affichage des dispositifs d'affichage à écran plat vers la surface d'affichage du dispositif d'affichage à tuiles.

3. Dispositif d'affichage à tuiles selon la revendication 2, dans lequel les surfaces d'affichage des dispositifs d'affichage à écran plat ont une première taille, et dans lequel les conducteurs de lumière transmettent la lumière provenant des surfaces d'affichage à une surface d'affichage du dispositif d'affichage à tuiles ayant une seconde taille supérieure à celle des surfaces d'affichage des dispositifs d'affichage à écran plat.

4. Dispositif d'affichage à tuiles selon la revendication 2 comportant des dalles individuelles alignées avec chaque dispositif d'affichage à écran plat sélectionné, dans lequel les bords adjacents des dalles individuelles sont alignés sous la forme d'une matrice et dans lequel les bords adjacents alignés des dalles sont inter digités dans au moins une dimension.

5. Dispositif d'affichage à tuiles selon la revendication 2 renfermant de multiples dispositifs d'affichage à écran plat sélectionnés alignés avec une seule dalle.

6. Dispositif d'affichage à tuiles selon la revendication 5, dans lequel les conducteurs de lumière transmettant la lumière depuis les éléments de pixels le long des bords adjacents des dispositifs d'affichage à écran plat sont inter digités au niveau de la surface d'affichage du dispositif d'affichage à tuiles dans au moins une dimension.

7. Dispositif d'affichage à tuiles selon la revendication 2 comprenant en outre un contrôleur permettant de corriger la sortie lumineuse de chaque conducteur de lumière par rapport à une luminosité, une couleur et un intervalle dynamique classiques.

8. Dispositif d'affichage à tuiles selon la revendication 2, dans lequel les dispositifs d'affichage à écran plat sont des dispositifs d'affichage à cristaux liquides.

9. Dispositif d'affichage à tuiles selon la revendication 2, dans lequel les dispositifs d'affichage à écran plat sont des dispositifs d'affichage à diodes luminescents organiques.

10. Dispositif d'affichage à tuiles selon la revendication 2, dans lequel les dispositifs d'affichage à écran plat sont des dispositifs d'affichage de type plasma.
